(19) Europäisches Patentamt
European Patent Office
Office européen des brevets

(11) **EP 2 251 702 B1**

(12) **EUROPÄISCHE PATENTSCHRIFT**

(45) Veröffentlichungstag und Bekanntmachung des Hinweises auf die Patenterteilung:
**13.07.2011  Patentblatt 2011/28**

(51) Int Cl.:
**G01R 19/165** *(2006.01)*       **G01R 29/16** *(2006.01)*
**G01R 31/02** *(2006.01)*       **G01R 31/42** *(2006.01)*

(21) Anmeldenummer: **09006104.5**

(22) Anmeldetag: **05.05.2009**

(54) **Verdrahtungs-Prüfvorrichtung**

Cabling test device

Dispositif de contrôle de câblage

(84) Benannte Vertragsstaaten:
**AT BE BG CH CY CZ DE DK EE ES FI FR GB GR HR HU IE IS IT LI LT LU LV MC MK MT NL NO PL PT RO SE SI SK TR**

(43) Veröffentlichungstag der Anmeldung:
**17.11.2010  Patentblatt 2010/46**

(73) Patentinhaber: **SMA Solar Technology AG**
**34266 Niestetal (DE)**

(72) Erfinder:
• **Wolf, Henrik**
**34123 Kassel (DE)**
• **Künzel, Benedikt**
**37308 Geisleden (DE)**
• **Bode, Christian**
**37434 Rollshausen (DE)**
• **Stickelman, Uwe**
**34260 Kaufungen (DE)**

(74) Vertreter: **Specht, Peter et al**
**Loesenbeck - Stracke - Specht - Dantz**
**Am Zwinger 2**
**33602 Bielefeld (DE)**

(56) Entgegenhaltungen:
**WO-A1-2006/126003     DE-A1-102007 046 921**

EP 2 251 702 B1

**Beschreibung**

Die Erfindung betrifft eine Verdrahtungs-Prüfvorichtung zum Prüfen einer Verdrahtung eines Wechselrichters zur Umwandlung einer Gleichspannung in eine dreiphasige Wechselspannung mit einem Netz, wobei der Wechselrichter zum Anschluss an das Niederspannungsdrehstromnetz mit netzseitigen Leiterspannungen gegen einen Neutralleiter ausgeführt ist Dreiphasige Wechselrichter dieser Art müssen von einem Installateur mit dem anzuschließenden Netz elektrisch verbunden werden. Hierbei müssen die verschiedenen Phasen und der Neutralleiter mit dem Netz korrespondierend angeschlossen werden. Bei der Verkabelung können jedoch Verdrahtungsfehler entstehen.

Aus der DE 692 19 055 T2 ist eine automatische Lokalisierung von einphasigen Erdungsfehlem in einem Mittelspannungsnetz bekannt. Hierbei werden Nullströme gemessen und eine Vektorsumme gebildet. Es erfolgt eine Überwachung der Phasenverschiebung der Einzelströme und der Vektorsumme.

Um Erdschlüsse in Hochspannungsnetzen mit einer Resonanzpunkterdung und einer Petersenspule zu erkennen, wird in der DE 10 2004 008 994 B4 vorgeschlagen, eine Spannungsunsymmetrie zur Fehlererkennung zu nutzen.

Bekannt sind auch Prüfgeräte, z. B. aus der DD 053 803 B1, mit denen impulsweise ein Kondensator zwischen einer erdschlussbehafteten Phase und dem Schutzleiter geschaltet wird, wobei der dort fließende Strom gemessen wird. Dadurch können erdschtussbehaftete Teile im Drehstromnetz ermittelt werden. Weitere Prüfgeräte, z. B. in der DE 10 2006 009 360 B3, stellen eine Drehfeldrichtung fest Hierbei wird ebenfalls ein Kondensator zwischen Phase und Neutralleiter eingesetzt.

Aus der DE 101 39 860 A1 ist ein Verfahren zur Erkennung eines fehlerhaften Anschlusses eines dreiphasigen Geräts bekannt. Anschlussiehler werden mittels dq-Transformation erkannt.

Um bei Schuko-Steckdosen fehlende oder vertauschte Anschlüsse prüfen zu können, wird in der DE 32 48 008 A1 eine Prüfschaltung für Anschlussfehler vorgeschlagen.

Eine Isolationsüberwachungsschaltung mit einem kapazitiven Teiler ist aus der WO 2008 152 466 A2 bekannt

Eine Messanordnung, mit der ein fehlender Anschluss einer Phase und/oder des Neutralleiters ermittelt werden kann, ist auch aus der Druckschrift DE 10 2007 046 921 A1 bekannt. Hierbei werden zwischen den Phasen und einem Neutralleiter abgeleitete Messpannungen mit einer Spannung an einem künstlich erzeugten Stempunkt verglichen. Der Stempunkt wird dabei durch ein passives Widerstandsnetzwerk gebildet, wobei folglich Wirkleistung umgesetzt wird.

Aus der Druckschrift WO 2006/126003 A1 ist eine Überwachung der Spannung auf verschiedenen Phasen in Zusammenhang mit einem Wechselrichter bekannt.

Der Erfindung liegt die Aufgabe zugrunde, eine Lösung zu finden, mit der ein Netzanschluss sowie Verdrahtungsfehler beim Anschluss an das Netz eines dreiphasigen Wechselrichters in einfacher Weise ohne Wirkleistungsumsatz geprüft werden können.

Diese Aufgabe wird durch eine Vorrichtung mit den Merkmalen des Anspruches 1 gelöst.

Durch die Erfindung ist eine Überwachung des korrekten Anschlusses an das Niederspannungs-Drehstromnetz mit Neutralleiter leicht möglich. Insbesondere ermöglicht die erfindungsgemäße Prüfvorrichtung, Installationsfehler bei der Montage eines PV-Wechselrichters automatisiert aufzudecken, sodass der Installateur auf eine komfortabte und einfache Art den Netzanschluss überprüfen kann. Die Prüfvorrichtung kann in dem Wechselrichter integriert sein, z. B. in dem Wechselrichtergehäuse untergebracht sein oder eine externe Schaltung sein, z. B. in Form eines externen Prüfgeräts.

Diese Prüfung erfolgt mit wenigen Messpunkten und einer einfachen Messschaltung, wobei wenig Bauelemente erforderlich sind, um eine großserientaugliche und kostengünstige Lösung zu erhalten.

Fehler, wie ein fehlender Anschluss einer oder zweier Phasen, eine Vertauschung von einer Phase und Neutralleiter und ein fehlender Neutralleiter auftreten.

Insgesamt können fünf Fehlerfälle auftreten.

Fall 1: Kein korrekter Anschluss des Drehstromnetzes an den Wechselrichter.
Fall 2: Eine Phase des Drehstromnetzes ist nicht am Wechselrichter angeschlossen.
Fall 3: Zwei Phasen des Drehstromnetzes sind nicht am Wechselrichter angeschlossen.
Fall 4: Der Neutralleiter des Drehstromnetzes ist nicht am Wechselrichter angeschlossen.
Fall 5: Eine Phase und der Neutralleiter des Drehstromnetzes sind vertauscht am Wechselrichter angeschlossen.

Die Erfindung beruht auf der Grundlage, dass die Summe der Leiterspannungen im Drehstromsystem Null ist, wenn alle Leiter korrekt angeschlossen sind. Fehlt einer der Leiterspannungen durch falsche Verdrahtung, so ist die Spannungssumme ungleich null.

Wenn die Größe $U_{Sum}$ für eine bestimmte Zeit $t_{Fehler}$ über eine Schwelle von $U_{Fehler}$ liegt, wird dem Installateur über eine Anzeige eine Fehlermeldung ausgegeben, dass ein Netzanschlussfehler vorliegt.

Nach diesem Grundsatz können die Fehlerfälle Fall 2, Fall 3 und Fall 5 eindeutig identifiziert werden. Es wird nur eine Größe zur Überwachung benötigt.

Zur Erkennung des fehlenden Neutralleiters bzw. im Fall 4 wird erfindungsgemäß das zusätzliche Bauelement zwischen einer Phase des Wechselrichters und dem Neutralleiteranschluss im Wechselrichter eingefügt. Bei Anschluss des Neutralleiters des Drehstromnetzes an den Wechselrichter fließt ein Strom über diese Phase, das Bauelement und den Neutralleiter zurück ins Netz. Bei vorhandenem Neutralleiter ist keine Spannungsunsymmetrie möglich, da der Sternpunkt durch den Neutralleiter festgelegt ist.

Wird der Neutralleiter jedoch nicht angeschlossen, kann der Strom über das zusätzliche Bauelement und dem Neutralleiter nicht zurück ins Netz fließen. In diesem Fall erzeugt das eingefügte Bauelement eine Unsymmetrie, die durch die Messung der Leiterspannungen erkannt wird. Bei dieser Unsymmetrie verschiebt sich der Stempunkt, sodass die Spannung am Bauelement unterschiedlich ist zu der Spannung, die bei korrekter Verdrahtung des Neutralleiters vorhanden ist. Durch diese Spannungsabweichung kann das Fehlen des Neutralleiters erkannt werden. Da für die Summenbildung alle Strang- bzw. Leiterspannungen gemessen werden, ist für diese Spannungsmessung kein zusätzlicher Aufwand erforderlich.

Weitere vorteilhafte Ausgestaltungen der Erfindung sind in den Unteransprüchen gekennzeichnet.

In einer vorteilhaften Weiterbildung der erfindungsgemäßen Vorrichtung ist vorgesehen, dass das zusätzliche Bauelement ein passives Bauelement ist.

Als Bauelement ist aus Kosten-, Verlust- und Komplexitätsgründen zweckmäßigerweise ein Kondensator vorgesehen. Dieser kann so dimensioniert sein, dass bei Nennbetrieb mit Netzspannung nur ein geringer kapazitiver Strom zwischen der Phase und dem Neutralleiter des Drehstromnetzes fließt, jedoch ausreichend ist für eine Unsymmetrie der Leiterspannungen. Als Alternative zu einem Kondensator ist ein Widerstand denkbar. Möglich wäre auch den Kondensator über einen Schalter ausschließlich für den Test zuzuschalten. Hierzu wäre eine zusätzliche Ansteuerung erforderlich.

Um einen korrekten Anschluss des Wechselrichters an das Drehstromnetz festzustellen, ist vorgesehen (Fehlerfall 1), dass symmetrisch an allen Phasen Kondensatoren angeschlossen sind, wobei diese vorzugsweise sternförmig geschaltet sind. Der zusätzliche Kondensator ist parallel zu einem der Kondensatoren geschaltet.

Eine besonders bevorzugte Weiterbildung der Erfindung zeichnet sich dadurch aus, dass zwischen dem Wechselrichter und dem Netz für jede Phase zwei in Reihe geschaltete Relaiskontakte angeordnet sind, wobei für jede Phase zwischen dem ersten und dem zweiten Relaiskontakt der Phase eine Spannungsmessung erfolgt. Hierdurch kann eine normgerechte galvanische Trennung zum Netz hin erreicht werden, die auch dann gegeben ist, wenn bei einem von zwei Relais ein Kontakt verschweißt ist. Hierbei ist wenigstens ein Kondensator, insbesondere alle Kondensatoren, zwischen einem Relaiskontakt und einer Anschlussklemme angeordnet.

Ein Ausführungsbeispiel wird anhand der Zeichnung näher erläutert, wobei weitere vorteilhafte Weiterbildungen der Erfindung und Vorteile derselben beschrieben sind.

Die Figur zeigt eine Verdrahtungs-Prüfvorrichtung 1 zum Prüfen einer Verdrahtung eines Wechselrichters 2, insbesondere eines Photovoltaikwechselrichters.

Der Wechselrichter 2 ist zum Anschluss an ein Niederspannungsdrehstromnetz 3 mit netzseitigen Leiterspannungen $u_1$, $u_2$, $u_3$ sowie mit einem Neutralleiter N ausgeführt. Vorhanden sind drei Strangspannungen $u_1$, $u_2$, $u_3$, z. B. $u_1$ gegen N-Leiter. Diese werden gemessen. Hierfür ist eine Messschaltung 4 zur Messung der Leiterspannungen $u_1$, $u_2$, $u_3$ vorhanden. Erfindungsgemäß wird ein Mittelwert aus der Summe der Augenblickswerte der Leiterspannungen $u_1$, $u_2$, $u_3$ berechnet. Diese wird über eine Netzperiode gemittelt. Eine Fehlermeldung wird dann ausgegeben, wenn diese Summenspannung für eine vorgegebene Zeit eine Schwellspannung überschreitet.

Die bevorzugte Ausführungsform nutzt dabei die Messung der netzseitigen Leiter- bzw. Strangspannungen, die u.a. bereits für einen Funktionstest von Netzrelais notwendig sind. Dabei wird der Betrag der Summe der Augenblickswerte gebildet. Dieser wird über eine Netzperiode gemittelt.

$$U_{SumHW}(k) = \left| u_1(k) + u_2(k) + u_3(k) \right|$$

$$U_{Sum} = [U_{SumHW}(k) + U_{SumHW}(k-1)] / N_{Netzperiode}$$

Wenn die Größe $U_{Sum}$ für eine bestimmte Zeit $t_{Fehler}$ über eine Schwelle von $U_{Fehler}$ liegt, wird dem Installateur über eine Anzeige eine Fehlermeldung ausgegeben, dass ein Netzanschlussfehler vorliegt.

Dadurch können direkt folgende Fehlerfälle erkannt werden:

- Eine Phase des Drehstromnetzes ist nicht am Wechselrichter angeschlossen.
- Zwei Phasen des Drehstromnetzes sind nicht am Wechselrichter angeschlossen.

- Eine Phase und der Neutralleiter des Drehstromnetzes sind vertauscht am Wechselrichter angeschlossen.

Es wird nur eine Größe zur Überwachung benötigt.

Wie die Figur veranschaulicht, ist zwischen L3 und dem Neutralleiter N ein zusätzliches passives Bauelement, und zwar ein Kondensator CN geschaltet. Dadurch entsteht bei fehlendem Neutralleiteranschluss eine Spannungsunsymmetrie. Diese ist durch die Messung der Leiterspannungen feststellbar, sodass eine Fehlermeldung auch bei fehlendem Neutralleiteranschluss ausgegeben wird.

Zudem sind drei Kondensatoren C1, C2 und C3 symmetrisch an allen Phasen L1, L2, L3 sternförmig angeschlossen. Der zusätzliche Kondensator CN ist parallel dem Kondensator C3 geschaltet.

Zwischen dem Wechselrichter 2 und dem Netz 3 sind für jede Phase L1-L3 mit Anschlussklemmen 2a, 2b, 2c in Reihe geschaltete Relaiskontakte 1 a, 1 b, 1 c angeordnet. Für jede Phase erfolgt zwischen dem Relaiskontakt, z. B. 1a und der Klemme 2a eine Spannungsmessung ($u_1$).

Die Kondensatoren C1, C2, C3 und CN sind netzseitig auf den Relaiskontakten 1 a, 1b, 1 c verdrahtet.

Vorzugsweise werden zur Messung der Leiterspannungen $u_1$, $u_2$, $u_3$ nicht gezeigte Operationsverstärkerschaltungen eingesetzt. Die Summenbildung der Leiterspannungen $u_1$ - $u_3$ kann durch einen Signalprozessor erfolgen.

## Bezugszeichenliste

| | |
|---|---|
| 1 | Verdrahtungs-Prüfvorrichtung |
| 2 | Wechselrichter |
| 3 | Niederspannungsdrehstromnetz |
| 4 | Messschaltung |
| 5 | Relaiskontakt |

| | |
|---|---|
| L1-L3 | Phasen |
| N | Neutralleiter |
| $u_1$-$u_3$ | Leiterspannungen |
| C1-C3 | Kondensatoren |
| CN | zusätzlicher Kondensator |
| 1a-1c | Relaiskontakte |
| 2a-2c | Anschlussklemmen vom Wechselrichter zum Niederspannungsnetz |

## Patentansprüche

1.  Verdrahtungs-Prüfvorrichtung (1) zum Prüfen einer Verdrahtung eines Wechselrichters (2) zur Umwandlung einer Gleichspannung in eine dreiphasige Wechselspannung, wobei der Wechselrichter (2) zum Anschluss an ein Niederspannungsdrehstromnetz (3) mit netzseitigen Leiterspannungen ($u_1$, $u_2$, $u_3$) gegen einen Neutralleiter (N) ausgeführt ist, wobei eine Messschaltung (4) zur Messung der Leiterspannungen ($u_1$, $u_2$, $u_3$) vorhanden ist, wobei ein Mittelwert aus der Summe der Augenblickswerte der Leiterspannungen ($u_1$, $u_2$, $u_3$) berechnet wird und wobei eine Fehlermeldung ausgegeben wird, wenn diese Summenspannung für eine vorgegebene Zeit eine Schwellspannung überschreitet,

    wobei ein zusätzliches Bauelement zwischen einer Phase (L1, L2 oder L3) und dem Neutralleiter (N) geschaltet ist, sodass bei fehlendem Neutralleiteranschluss eine Spannungsunsymmetrie entsteht, die durch die Messung der Leiterspannungen feststellbar ist, sodass eine Fehlermeldung auch bei fehlendem Neutralleiterenschluss ausgegeben wird,

    **dadurch gekennzeichnet, dass** das zusätzliche Bauelement ein Kondensator (CN) ist.

2.  Vorrichtung nach einem der Ansprüche 2 oder 3,
    **dadurch gekennzeichnet,**
    **dass** symmetrisch an allen Phasen (L1, L2, L3) Kondensatoren (C1, C2, C3) angeschlossen sind,

3.  Vorrichtung nach Anspruch 4,
    **dadurch gekennzeichnet,**
    **dass** die Kondensatoren (C1, C2, C3) sternförmig geschaltet sind, wobei das zusätzliche Bauelement parallel zu einem der Kondensatoren (C1, C2, C3) geschaltet ist.

**4.** Vorrichtung nach einem der vorhergehenden Ansprüche,
**dadurch gekennzeichnet,**
**dass** zwischen dem Wechselrichter (2) und dem Netz (3) für jede Phase (L1, L2, L3) mit Anschlussklemmen (2a, 2b, 2c) in Reihe geschaltete Relaiskontakte (1a, 1b, 1c) angeordnet sind, wobei die Messschaltung (4) dazu eingerichtet ist, eine Spannungsmessung für jede Phase (L1, L2, L3) an einem zwischen dem Relaiskontakt (1a, 1b, 1c) und der jeweiligen Anschlussklemme (2a, 2b, 2c) gelegenen Messpunkt auszuführen.

**5.** Vorrichtung nach einem der vorhergehenden Ansprüche,
**dadurch gekennzeichnet,**
**dass** die Messschaltung (4) Operationsverstärkerschaltungen zur Messung der Leiterspannungen ($u_1$, $u_2$, $u_3$) umfasst.

**6.** Vorrichtung nach einem der vorhergehenden Ansprüche,
**dadurch gekennzeichnet,**
**dass** die Messschaltung (4) einen Signalprozessor zur Summenbildung der Leiterspannungen ($u_1$, $u_2$, $u_3$) umfasst.

**Claims**

**1.** Wiring test apparatus (1) for testing of a wiring of an inverter (2) for conversion of a DC voltage to a three-phase AC voltage, wherein the inverter (2) is designed for connection to a low-voltage pole phase power supply system (3) with conductor voltages ($u_1$, $u_2$, $u_3$) with respect to a neutral conductor (N) on the power supply system side, wherein a measurement circuit (4) is provided for measurement of the conductor voltages ($u_1$, $u_2$, $u_3$), wherein a mean value is calculated from the sum of the instantaneous values of the conductor voltages ($u_1$, $u_2$, $u_3$), and wherein a fault message is emitted if this sum voltage exceeds a threshold voltage for a predetermined time,
wherein an additional component is connected between one phase (L1, L2 or L3) and the neutral conductor (N) such that a faulty neutral conductor connection results in a voltage unbalance which can be detected by measurement of the conductor voltages, such that a fault message is emitted even if there is no neutral conductor connection
**characterized**
**in that** the additional component is a capacitor (CN).

**2.** Apparatus according to one of Claims 2 or 3, **characterized**
**in that** capacitors (C1, C2, C3) are connected in a balanced form to all the phases (L1, L2, L3).

**3.** Apparatus according to Claim 4,
**characterized**
**in that** the capacitors (C1, C2, C3) are connected in the form of star, with the additional component being connected in parallel with one of the capacitors (C1, C2, C3).

**4.** Apparatus according to one of the preceding claims,
**characterized**
**in that** relay contacts (1a, 1b, 1c) which are connected in series with connecting terminals (2a, 2b, 2c) for each phase (L1, L2, L3) are arranged between the inverter (2) and the power supply (3), wherein the measurement circuit (4) is designed to carry out a voltage measurement for each phase (L1, L2, L3) at a measurement point which is located between the relay contact (1a, 1b, 1c) and the respective connecting terminal (2a, 2b, 2c).

**5.** Apparatus according to one of the preceding claims,
**characterized**
**in that** the measurement circuit (4) comprises operational amplifier circuits for measurement of the conductor voltages ($u_1$, $u_2$, $u_3$).

**6.** Apparatus according to one of the preceding claims,
**characterized**
**in that** the measurement circuit (4) comprises a signal processor for forming the sum of the conductor voltages ($u_1$, $u_2$, $u_3$).

**Revendications**

1. Dispositif de contrôle de câblage (1) destiné à contrôler un câblage d'un onduleur (2) servant à convertir une tension continue en une tension alternative triphasée, lequel onduleur (2) est configuré pour être connecté à un réseau triphasé basse tension (3) avec des tensions de phases côté réseau ($u_1$, $u_2$, $u_3$) par rapport à un conducteur de neutre (N), le dispositif comprenant un circuit de mesure (4) pour mesurer les tensions de phases ($u_1$, $u_2$, $u_3$), avec calcul d'une moyenne à partir de la somme des valeurs instantanées des tensions de phases ($u_1$, $u_2$, $u_3$) et émission d'un message d'erreur lorsque cette tension sommée dépasse une tension de seuil pendant une durée prédéterminée,

   un composant supplémentaire étant connecté entre une phase (L1, L2 ou L3) et le conducteur de neutre (N) de telle façon que, lorsque le conducteur de neutre n'est pas raccordé, il en résulte une asymétrie de tension qui peut être déterminée par la mesure des tensions de phases afin d'émettre un message d'erreur même lorsque le conducteur de neutre n'est pas raccordé,

   **caractérisé en ce que** le composant supplémentaire est un condensateur (CN).

2. Dispositif selon l'une des revendications 2 ou 3,
   **caractérisé en ce que** des condensateurs (C1, C2, C3) sont connectés de manière symétrique à toutes les phases (L1, L2, L3).

3. Dispositif selon la revendication 4,
   **caractérisé en ce que** les condensateurs (C1, C2, C3) sont câblés en étoile, le composant supplémentaire étant connecté en parallèle à l'un des condensateurs (C1, C2, C3).

4. Dispositif selon l'une des revendications précédentes,
   **caractérisé en ce que**, pour chaque phase (L1, L2, L3), des contacts de relais (1a, 1b, 1 c) câblés en série au moyen de bornes de connexion (2a, 2b, 2c) sont disposés entre l'onduleur (2) et le réseau (3), le circuit de mesure (4) étant agencé pour effectuer, pour chaque phase (L1, L2, L3), une mesure de tension en un point de mesure situé entre le contact de relais (1a, 1b, 1c) et la borne de connexion (2a, 2b, 2c) correspondante.

5. Dispositif selon l'une des revendications précédentes,
   **caractérisé en ce que** le circuit de mesure (4) comprend des circuits à base d'amplificateurs opérationnels pour la mesure des tensions de phases ($u_1$, $u_2$, $u_3$).

6. Dispositif selon l'une des revendications précédentes,
   **caractérisé en ce que** le circuit de mesure (4) comprend un processeur de signal pour la sommation des tensions de phases ($u_1$, $u_2$, $u_3$).

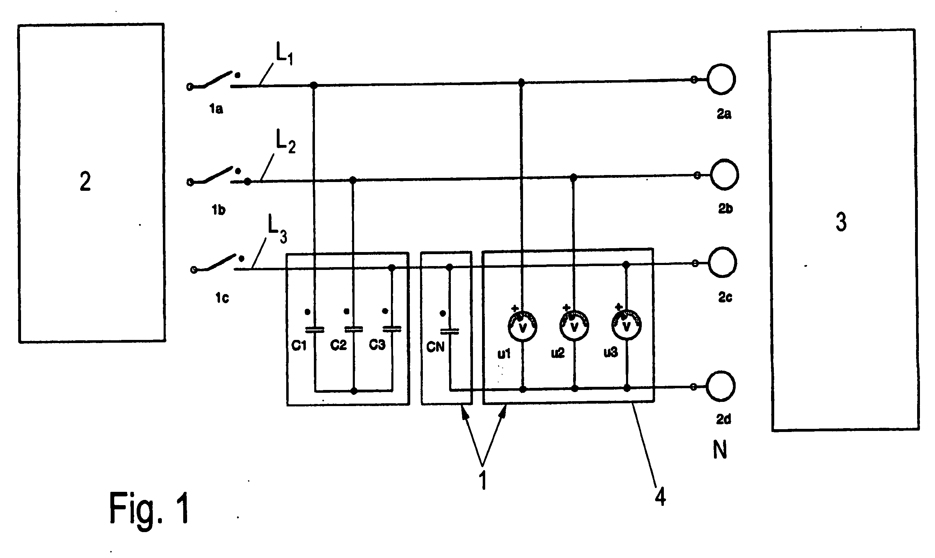

Fig. 1

7

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69219055 T2
- DE 102004008994 B4
- DD 053803 B1
- DE 102006009360 B3
- DE 10139860 A1
- DE 3248008 A1
- WO 2008152466 A2
- DE 102007046921 A1
- WO 2006126003 A1